# EUROPEAN PATENT APPLICATION

(11) **EP 4 838 274 A1**
(43) Date of publication of application: **11.11.2026**
(21) Application number: 25175382.8
(22) Date of filing: 09.05.2025
(51) Int. Cl.: G02B 6/12, G02B 6/13, G02B 6/42, H01L 23/00

(54) **PHOTONIC INTEGRATED CIRCUIT, OPTO-ELECTRONIC ASSEMBLY AND OPTO-ELECTRONIC SYSTEM**

(71) Applicant: EFFECT Photonics B.V., 5656 AE Eindhoven (NL)
(72) Inventor: Kelly, Niall Patrick, 5656AE Eindhoven (NL); Koene, Tim, 5656AE Eindhoven (NL)
(74) Representative: Kramer-Ograjensek, Petra

(57) **Abstract**

The invention relates to a photonic integrated circuit (1) for hybrid integration with an electronic integrated circuit (6) that comprises a first set of electrically conductive contact pads (10). The photonic integrated circuit comprises a set of recessed surfaces (13) providing a placeholder area or docking pad (5) with which the electronic integrated circuit can be associated via an adhesive material (25). The placeholder area or docking pad is surrounded by a second set of electrically conductive contact pads (17). If the electronic integrated circuit and the photonic integrated circuit are glued together via the adhesive material, electrical connections between the first set of electrically conductive contact pads and the second set of electrically conductive contact pads can be established using wires (20) and/or ribbons (21) of electrically conducting material.

The invention also relates to an opto-electronic assembly (100) and an opto-electronic system (200) comprising said photonic integrated circuit.

## Description

### FIELD OF THE INVENTION

The present invention relates to a photonic integrated circuit. The invention also relates to an opto-electronic assembly comprising the photonic integrated circuit according to the invention, and to an opto-electronic system comprising the photonic integrated circuit and/or the opto-electronic assembly according to the invention. The opto-electronic system according to the invention can be used for example, but not exclusively, for telecommunication applications, Light Detection and Ranging (LIDAR) or sensor applications.

### BACKGROUND OF THE INVENTION

There has been significant progress in recent years in realizing monolithically integrated opto-electronic assemblies and opto-electronic systems, i.e. assemblies and systems in which photonic integrated circuits and electronic integrated circuits are integrated on a same substrate without using at least one of wire bonds, ribbon bonds and flip-chip metal bumps for electrically interconnecting the photonic integrated circuit and the electronic integrated circuit. However, there are still some electrical components, e.g. thermistors and RF terminations, for which monolithic integration using available photonic fabrication processes, e.g. InP-based process technology, remains challenging if not impossible.

Especially in the case of increasingly complex opto-electronic assemblies and systems, hybrid integration of photonic integrated circuits and electronic integrated circuits is still required. Unfortunately, known hybrid integration solutions can give rise to for example at least one of variations in etch loading and photoresist pooling during fabrication of a photonic integrated circuit that is configured to provide a dedicated large area, i.e. an area taking up 10% to 40% of a total surface area of the substrate of the photonic integrated circuit, with which an electronic integrated circuit can be associated. Additionally or alternatively, the known hybrid integration solutions can suffer from poor adhesion of the electronic integrated circuit to the photonic integrated circuit. This can result in at least partial detachment of the electronic integrated circuit from the photonic integrated circuit. Such at least partial detachment can cause performance and/or reliability issues of the hybridly integrated opto-electronic assembly.

In the context of this invention, etch loading refers to an amount of material that needs to be removed from the substrate of the photonic integrated circuit during an etching process. Etching processes are optimized for a certain etch loading. Variations in etch loading can negatively impact at least one of control, quality and reproducibility of the etching process. Variations in etch loading can be caused by the many different and increasingly complex layouts of the photonic integrated circuits that are provided with the above-mentioned dedicated large area with which the electronic integrated circuits can be associated to arrive at a hybridly integrated opto-electronic assembly. Because of the variations in etch loading it would be ideal if a dedicated etching process would be available for each different layout. This approach is of course highly undesirable for any processing facility because of the time and costs that would be involved with the vast number of dedicated etching processes that would have to be developed and maintained.

In the context of this invention, photoresist pooling refers to accumulation of photoresist in a large recessed area that is etched in the substrate of a photonic integrated circuit for providing the above-mentioned dedicated large area with which an electronic integrated circuit can be associated. Photoresist pooling is undesirable because it can negatively impact at least one of control, quality and reproducibility of photolithography processes used during fabrication of the photonic integrated circuit.

Based on the above, it is clear that at least one of etch loading, photoresist pooling and adhesion problems can contribute to a compromised yield and/or reliability of the photonic integrated circuit and consequently of the opto-electronic assembly and/or the opto-electronic system in which the photonic integrated circuit is applied. Therefore, there is a need for providing a photonic integrated circuit that can pre-empt or at least reduce the above-mentioned and/or other disadvantages caused by the above-mentioned fabrication related issues that are associated with known solutions for hybrid integration of electronic integrated circuits with increasingly complex photonic integrated circuits.

### SUMMARY OF THE INVENTION

It is an object of the present invention to provide a photonic integrated circuit that can pre-empt or at least reduce at least one of the above-mentioned and/or other disadvantages caused by the above-mentioned fabrication related issues that are associated with known solutions for hybrid integration of electronic integrated circuits with increasingly complex photonic integrated circuits.

It is another object of the present invention to provide an opto-electronic assembly that comprises a photonic integrated circuit according to the invention and an electronic integrated circuit that are electrically interconnected via at least one of wires of electrically conductive material and ribbons of electrically conductive material.

It is yet another object of the present invention to provide an opto-electronic system comprising a photonic integrated circuit according to the invention and/or an opto-electronic assembly according to the invention. The opto-electronic system according to the invention can be used for example, but not exclusively, for telecommunication applications, LIDAR or sensor applications.

Aspects of the present invention are set out in the accompanying independent and dependent claims. Features from the dependent claims may be combined with features from the independent claim as appropriate and not merely as explicitly set out in the claims. Furthermore, all features may be replaced with other technically equivalent features.

At least one of the abovementioned objects is achieved by a photonic integrated circuit for hybrid integration with an electronic integrated circuit, the photonic integrated circuit comprising:
- a semiconductor-based substrate that comprises a first side and a second side, the first side and the second side being arranged parallel to each other and facing away from each other, wherein the first side of the semiconductor-based substrate is provided with a placeholder area for allowing association of the photonic integrated circuit with an electronic integrated circuit that comprises a substrate having a third side and a fourth side, the third side and the fourth side being arranged parallel to each other and facing away from each other, the substrate being provided with a first set of electrically conductive contact pads, at least one electrically conductive contact pad of the first set of electrically conductive contact pads being accessible at the third side of the substrate or via the third side of the substrate, each electrically conductive contact pad of the first set of electrically conductive contact pads having a fifth side and a sixth side, the sixth side being associated with the substrate of the electronic integrated circuit and the fifth side being arranged facing away from the first side of the semiconductor-based substrate if the fourth side of the substrate of the electronic integrated circuit is associated with the placeholder area, the placeholder area having a first surface area, A₁, that is in a first range between 0.05mm² and 10mm², and wherein the semiconductor-based substrate in the placeholder area is provided with a set of recessed surfaces, wherein a respective recessed surface of the set of recessed surfaces:
   - is arranged parallel to the second side of the semiconductor-based substrate;
   - has a second surface area, A₂, that is in a second range between 100µm² and 10,000µm²;
   - is arranged at a distance, D, from a neighboring recessed surface of the set of recessed surfaces as seen in a direction parallel to the second side of the semiconductor-based substrate, the distance, D, being in a third range between 1µm and 100µm; and
   - is enclosed by a respective side wall comprising semiconductor-based material, the respective side wall having an end portion comprising a seventh side that is arranged parallel to the second side of the semiconductor-based substrate at a height, H, from the respective recessed surface as seen in a direction transverse to the second side of the semiconductor-based substrate; and
- a second set of electrically conductive contact pads, at least one electrically conductive contact pad of the second set of electrically conductive contact pads being accessible at the first side of the semiconductor-based substrate or via the first side of the semiconductor-based substrate, each electrically conductive contact pad of the second set of electrically conductive contact pads having an eighth side and a ninth side, the ninth side being associated with the semiconductor-based substrate and the eighth side being arranged facing away from the first side of the semiconductor-based substrate, the second set of electrically conductive contact pads being configured and arranged relative to the placeholder area to allow, if an electronic integrated circuit is associated with the placeholder area, establishment of electrical connections between fifth sides of electrically conductive contact pads of the first set of electrically conductive contact pads and eighth sides of electrically conductive contact pads of the second set of electrically conductive contact pads using at least one of wires of electrically conducting material and ribbons of electrically conducting material.

The set of recessed surfaces that are provided to the semiconductor-based substrate in the placeholder area can have any suitable number of recessed surfaces for establishing a placeholder area that has a first surface area A₁ with a value in the above-mentioned first range between 0.05mm² and 10mm². The seventh sides of the respective side walls are arranged to enclose the respective recessed surfaces of the set of recessed surfaces and to allow reliable association of an electronic integrated circuit with the placeholder area of the photonic integrated circuit. The placeholder area can have a perimeter of any suitable shape, for example a polygonal shape, e.g. rectangular, square, L-shaped or T-shaped, an elliptical shape, e.g. circular or oval, or a composite shape, i.e. a combination of interconnected straight sections and curved sections, wherein the curved sections can provide for example rounded corners. In this way, it is possible to adapt the perimeter of the placeholder area to a perimeter of the electronic integrated circuit that is to be reliably associated with the placeholder area of the photonic integrated circuit.

In the event that an electronic integrated circuit has an area that is smaller than the first surface area A₁ of the placeholder area, the electronic integrated circuit can be associated with a part of the placeholder area and therefore with a subset of the respective side walls that are arranged to enclose respective recessed surfaces of the set of recessed surfaces. In the event that the area of the electronic integrated circuit is equal to the first surface area A₁ of the placeholder area, the electronic integrated circuit can be associated with all respective side walls that are arranged to enclose the respective recessed surfaces of the set of recessed surfaces.

As the second surface area *A*₂ of each of the recessed surfaces of the set of recessed surfaces that are provided to the semiconductor-based substrate in the placeholder area can have any value in the above-mentioned second range between 100µm² and 10,000µm², and the distance D between neighboring recessed surfaces of the set of recessed surfaces as seen in the direction parallel to the second side of the semiconductor-based substrate can have any value in the above-mentioned third range between 1µm and 100µm, the placeholder area, which can be construed as a structured placeholder area contrary to unstructured or flat recessed areas or unstructured or flat elevated areas known from the prior art, can be configured and arranged to reduce and preferably minimize at least one of variations in etch loading and photoresist pooling. By allowing reduction and preferably minimization of at least one of variations in etch loading and photoresist pooling, the structured placeholder area can achieve an improved reliability of manufacturing and/or an improved yield of the photonic integrated circuit according to the present invention.

It is noted that it is possible that of some recessed surfaces of the set of recessed surfaces the second surface area *A*₂ has a first value that is in the above-mentioned second range, and of other recessed surfaces of the set of recessed surfaces the second surface area *A*₂ has a second value that is in the above-mentioned second range in order to achieve a configuration of the recessed surfaces of the set of recessed surfaces in the placeholder area that enables meeting requirements regarding reduction and preferably minimization of variations in etch loading and/or reduction and preferably minimization of photoresist pooling. Based on the foregoing it is clear that the configurability of the recessed surfaces of the set of recessed surfaces in the placeholder area can improve the robustness of the fabrication process and consequently the yield and/or reliability of the photonic integrated circuit according to the present invention.

Because the electrically conductive contact pads of the second set of electrically conductive contact pads of the photonic integrated circuit and the electrically conductive contact pads of the first set of electrically conductive contact pads of the electronic integrated circuit are not facing towards each other if the electronic integrated circuit is associated with the placeholder area of the photonic integrated circuit according to the invention, wire bonding and/or ribbon bonding can be used for establishing electrical connections between electrically conductive contact pads of the second set of electrically conductive contact pads and electrically conductive contact pads of the first set of electrically conductive contact pads. The person skilled in the art will appreciate that the way of associating an electronic integrated circuit and a photonic integrated circuit with each other as enabled by the photonic integrated circuit according to the present invention is advantageous in comparison with flip-chip mounting that is more tedious and laborious as the electrically conductive contact pads of the first set of electrically conductive contact pads and the electrically conductive contact pads of the second set of electrically conductive contact pads would need to be arranged facing towards each other. It is noted that in the context of the present invention, the way in which an electronic integrated circuit and a photonic integrated circuit are arranged relative to each, after being associated with each other, can be referred to as a back-to-face arrangement, i.e. the backside of the substrate of the electronic integrated circuit and the frontside or face of the semiconductor-based substrate of the photonic integrated circuit are arranged facing towards each other and the electrically conductive contact pads for establishing electrical interconnections between the electronic integrated circuit and the photonic integrated circuit via at least one of wires and ribbons of electrically conducting material are arranged facing away from each other. In accordance with this definition, the way in which an electronic integrated circuit and a photonic integrated circuit are arranged relative to each other, after being associated with each other, using flip-chip mounting can be referred to as a face-to-face arrangement, i.e. the frontside or face of the substrate of the electronic integrated circuit and the frontside or face of the semiconductor-based substrate of the photonic integrated circuit are arranged facing towards each other and the electrically conductive contact pads for establishing electrical interconnections between the electronic integrated circuit and the photonic integrated circuit are arranged facing towards each other.

The structured placeholder area at the first side of the semiconductor-based substrate of the photonic integrated circuit according to the invention is configured and arranged to allow at least one of reliable processing of the photonic integrated circuit, reliable adhesive association of at least one electronic integrated circuit with the photonic integrated circuit, and the use of wire bonding and/or ribbon bonding for establishing electrical interconnects between the electronic integrated circuit and the photonic integrated circuit.

The photonic integrated circuit according to the invention can also be provided with a plurality of structured placeholder areas wherein the respective structured placeholder areas of the plurality of structured placeholder areas can be arranged at different locations at the first side of the semiconductor-based substrate of the photonic integrated circuit. Each respective structured placeholder area of the plurality of structured placeholder areas can be configured an arranged differently depending on for example a respective electronic integrated circuit that is to be associated with the respective placeholder area.

In an embodiment of the photonic integrated circuit according to the invention, the recessed surfaces of the set of recessed surfaces are uniformly distributed or non-uniformly distributed over the placeholder area. Depending on the specific layout of the photonic integrated circuit, the uniform distribution or the non-uniform distribution of the recessed surfaces over the placeholder area can be advantageous for meeting requirements regarding reduction and preferably minimization of variations in etch loading and/or reduction and preferably minimization of photoresist pooling during fabrication of the photonic integrated circuit according to the invention.

It is noted that in the context of the present invention, a uniform distribution of the recessed surfaces of the set of recessed surfaces over the placeholder area can be construed as a distribution in accordance with which a regular pattern of recessed surfaces in the placeholder area can be distinguished. It is possible that the placeholder area is configured to have a first region with a first regular pattern of recessed surfaces and a second region with a second regular pattern of recessed surfaces, wherein the first regular pattern and the second regular pattern are different. It is noted that the number of regions with different regular patterns of recessed surfaces can be any number depending on the specific requirements for the photonic integrated circuit.

Furthermore, in the context of the present invention, a non-uniform distribution of the recessed surfaces of the set of recessed surfaces over the placeholder area can be construed as a distribution in accordance with which no regular pattern of recessed surfaces in the placeholder area can be distinguished. Again, it is possible that the placeholder area is configured to have a first region with a first irregular pattern of recessed surfaces and a second region with a second irregular pattern of recessed surfaces, wherein the first irregular pattern and the second irregular pattern are different. It is noted that the number of regions with different irregular patterns of recessed surfaces can be any number depending on the specific requirements for the photonic integrated circuit.

In an embodiment of the photonic integrated circuit according to the invention, the placeholder area has a first region in which a first subset of recessed surfaces of the set of recessed surfaces are uniformly distributed, and a second region in which a second subset of recessed surfaces of the set of recessed surfaces are non-uniformly distributed. In this way, an additional degree of freedom can be provided regarding reduction and preferably minimization of variations in etch loading and/or reduction and preferably minimization of photoresist pooling during fabrication of the photonic integrated circuit according to the invention.

In an embodiment of the photonic integrated circuit according to the invention, the height, H, is in a fourth range between 1µm and 10µm. In this way, another additional degree of freedom can be provided regarding reduction and preferably minimization of variations in etch loading and/or reduction and preferably minimization of photoresist pooling during fabrication of the photonic integrated circuit according to the invention.

In an embodiment of the photonic integrated circuit according to the invention, the respective side wall is arranged to provide the respective recessed surface of the set of recessed surfaces that is enclosed by the respective side wall with a perimeter having a polygonal shape or an elliptical shape. The polygonal shape can be any suitable shape enabling the respective side wall to reliably support an electronic integrated circuit, e.g. rectangular, square, L-shaped or T-shaped. Similarly, the elliptical shape can be any suitable shape enabling the respective side wall to reliably support an electronic integrated circuit, e.g. circular or oval.

In an embodiment of the photonic integrated circuit according to the invention, the respective side wall is arranged to provide the respective recessed surface of the set of recessed surfaces that is enclosed by the respective side wall with a perimeter having a composite shape that comprises interconnected straight sections and curved sections. The composite shape of the perimeter of the respective side wall can be any suitable shape enabling the respective side wall to reliably support an electronic integrated circuit.

In an embodiment of the photonic integrated circuit according to the invention, the semiconductor-based substrate comprises InP-based material, and is associated with a layer stack comprising at least one epitaxial semiconductor-based layer, the layer stack having a tenth side and an eleventh side that are arranged parallel to each other and facing away from each other, the tenth side being associated with the first side of the semiconductor-based substrate, wherein respective side walls that are arranged to enclose respective recessed surfaces of the set of recessed surfaces comprise InP-based material of the semiconductor-based substrate and/or semiconductor-based material of the at least one epitaxial semiconductor-based layer of the layer stack.

In the event that the layer stack comprises more than one epitaxial semiconductor-based layer, the epitaxial semiconductor-based layers can be configured to provide optical functionality if the photonic integrated circuit is in use. The respective side walls of the above-mentioned kind that are provided in the placeholder area of the photonic integrated circuit according to the invention have sufficient mechanical strength for providing reliable support of an electronic integrated circuit.

According to another aspect of the present invention, an opto-electronic assembly is provided comprising:
- a photonic integrated circuit according to the invention; and
- an electronic integrated circuit that comprises a substrate comprising a third side and a fourth side, the third side and the fourth side being arranged parallel to each other and facing away from each other, the fourth side of the substrate being associated with the placeholder area at the first side of the semiconductor-based substrate of the photonic integrated circuit, the substrate being provided with a first set of electrically conductive contact pads, at least one electrically conductive contact pad of the first set of electrically conductive contact pads being accessible at the third side of the substrate or via the third side of the substrate, each electrically conductive contact pad of the first set of electrically conductive contact pads having a fifth side and a sixth side, the sixth side being associated with the substrate of the electronic integrated circuit and the fifth side being arranged facing away from the first side of the semiconductor-based substrate of the photonic integrated circuit;
wherein fifth sides of electrically conductive contact pads of the first set of electrically conductive contact pads of the electronic integrated circuit and eighth sides of electrically conductive contact pads of the second set of electrically conductive contact pads of the photonic integrated circuit are electrically interconnected via at least one of wires of electrically conducting material and ribbons of electrically conducting material.

Because the electrically conductive contact pads of the second set of electrically conductive contact pads of the photonic integrated circuit and the electrically conductive contact pads of the first set of electrically conductive contact pads of the electronic integrated circuit are not facing towards each other, i.e. the electronic integrated circuit and the photonic integrated circuit are in the above-mentioned back-to-face arrangement, wire bonding and/or ribbon bonding can be used for establishing electrical connections between eighth sides of electrically conductive contact pads of the second set of electrically conductive contact pads and fifth sides of electrically conductive contact pads of the first set of electrically conductive contact pads. In this way, flip-chip mounting, which is more tedious and laborious as the electrically conductive contact pads of the first set of electrically conductive contact pads and the electrically conductive contact pads of the second set of electrically conductive contact pads would need to be arranged facing towards each other, can be avoided.

The above-mentioned advantages regarding the photonic integrated circuit according to the invention mutatis mutandis apply to the opto-electronic assembly according to the invention as it comprises said photonic integrated circuit.

In an embodiment of the opto-electronic assembly according to the invention, the electronic integrated circuit and the placeholder area of the photonic integrated circuit are associated with each other via an adhesive material to establish a mechanical connection between the electronic integrated circuit and the photonic integrated circuit. The adhesive material can be any type of material, e.g. an epoxy resin, suitable for reliably gluing the substrate of the electronic integrated circuit and the placeholder area of the photonic integrated circuit together. An advantage of using adhesive material for associating the electronic integrated circuit and the photonic integrated circuit is that bonding techniques such as for example thermo-compression bonding can be omitted. The adhesive material can be the only material between the substrate of the electronic circuit and the placeholder area of the photonic integrated circuit. It is also possible that in addition to the adhesive material, one or more other materials are arranged between the substrate of the electronic circuit and the placeholder area of the photonic integrated circuit as part of the mechanical connection between the electronic integrated circuit and the photonic integrated circuit.

In an embodiment of the opto-electronic assembly according to the invention, the adhesive material is arranged in contact with one of:
- a seventh side of an end portion of at least one respective side wall that is arranged to enclose a respective recessed surface of the set of recessed surfaces in the placeholder area of the photonic integrated circuit and the fourth side of the substrate of the electronic integrated circuit;
- a seventh side of an end portion of at least one respective side wall that is arranged to enclose a respective recessed surface of the set of recessed surfaces in the placeholder area of the photonic integrated circuit and a first intermediate medium that is arranged in contact with the fourth side of the substrate of the electronic integrated circuit, the first intermediate medium comprising at least one of a polymer layer, a dielectric layer, and a metal layer;
- the fourth side of the substrate of the electronic integrated circuit and a second intermediate medium that is arranged in contact with a seventh side of an end portion of at least one respective side wall that is arranged to enclose a respective recessed surface of the set of recessed surfaces in the placeholder area of the photonic integrated circuit, the second intermediate medium comprising at least one of a polymer layer, a dielectric layer, and a metal layer;
- a first intermediate medium that is arranged in contact with the fourth side of the substrate of the electronic integrated circuit and a second intermediate medium that is arranged in contact with a seventh side of an end portion of at least one respective side wall that is arranged to enclose a respective recessed surface of the set of recessed surfaces in the placeholder area of the photonic integrated circuit, each of the first intermediate medium and the second intermediate medium comprising at least one of a polymer layer, a dielectric layer, and a metal layer.

It is noted that it is possible that the adhesive material is arranged in contact with a seventh side of an end portion of a first side wall that is arranged to enclose a first recessed surface of the set of recessed surfaces and with a second intermediate medium that is arranged in contact with a seventh side of an end portion of a second side wall that is arranged to enclose a second recessed surface of the set of recessed surfaces. The first recessed surface and the second recessed surface can be neighboring recessed surfaces of the set of recessed surfaces in the placeholder area of the photonic integrated circuit according to the invention.

The adhesive material can be of any type, for example an epoxy resin, suitable for reliably gluing at least two of the semiconductor material of the respective side walls that are arranged to enclose respective recessed surfaces of the set of recessed surfaces in the placeholder area, the substrate of the electronic integrated circuit, the first intermedium medium and the second intermediate medium together.

At least one of the first intermediate medium and the second intermediate medium can be used for at least one of planarization, environmental protection and adhesion enhancement purposes. Depending on the specific purpose, the first intermediate medium and the second intermediate medium can comprise any suitable number of layers, e.g. zero, one, two, three, etc., of at least one of a polymer layer, such as benzocyclobutene (BCB), a dielectric layer, such as silicon nitride (SiNₓ), silicon oxide (SiOₓ), silicon oxynitride (SiONₓ), and a metal layer, such as gold (Au). Depending on the specific purpose, the first intermediate medium can comprises any suitable stack of layers having any suitable composition and any suitable thickness. The same holds for the second intermediate medium.

For example, the first intermediate medium can comprise a single polymer layer having any composition and thickness suitable for its intended purpose, whereas the second intermediate medium, if applied, can comprise for example two polymer layers having a same or different thickness and a same or different composition, wherein the two polymer layers can be separated by at least one of a dielectric layer and a metal layer having any suitable composition and thickness depending on the specific purpose of the second intermediate medium.

It is noted that if in the context of the present invention at least one of the first intermediate medium and the second intermediate medium comprises a metal layer, the respective metal layer is not applied for establishing or facilitating any kind of electrical interaction or connection between the electronic integrated circuit and the photonic integrated circuit. Despite the foregoing, the respective metal layer of at least one of the first intermediate medium and the second intermediate medium can be used for electrical functionality such as routing of electrical signals across at least one of the photonic integrated circuit and the electronic integrated circuit.

In an embodiment of the opto-electronic assembly according to the invention, the adhesive material comprises an epoxy resin. The epoxy resin, which can for example be a silver-filled epoxy or a non-silver-filled epoxy such as for example a boron-nitride-filled epoxy, can be used to glue the electronic integrated circuit and the photonic integrated circuit together.

In an embodiment of the opto-electronic assembly according to the invention, the wires of electrically conducting material and/or the ribbons of electrically conducting material comprise a metal. Any suitable metal, metal alloy or coated metal can be used provided that it at least has good electrical conductivity and is compatible with wire bonding and/or ribbon bonding processes.

Non-limiting examples of suitable metals are gold, copper and aluminum. Non-limiting examples of suitable metal alloys are gold alloy and copper alloy. A non-limited example of a suitable coated metal is palladium coated copper. Gold is widely used in wire bonding and/or ribbon bonding due to its excellent electrical conductivity and high corrosion resistance. Copper has excellent electrical conductivity and thermal conductivity and is relatively cheap. Copper alloy comprises a metal different from copper that enhances mechanical strength and wear resistance compared to pure copper. Aluminum has excellent moisture resistance. Palladium coated copper offers improved oxidation resistance but is relatively expensive.

In an embodiment of the opto-electronic assembly according to the invention, the metal comprises gold. An example is gold-plated copper or gold-plated silver. These gold-plated solutions offer many of the benefits of pure gold, such as corrosion resistance, while maintaining the strength and lower cost of the copper or silver onto which the gold is plated. Gold alloys, e.g. gold-aluminum or gold-palladium, can also be used.

According to yet another aspect of the present invention, an opto-electronic system is provided comprising a photonic integrated circuit and/or an opto-electronic assembly according to the invention, wherein the opto-electronic system is one of a transmitter, a receiver, a transceiver, a coherent transmitter, a coherent receiver and a coherent transceiver. The opto-electronic system can for example, but not exclusively, be used for telecommunication applications, LIDAR or sensor applications. Based on the above, the person skilled in the art will appreciate that any one of the above-mentioned transmitters, receivers and transceivers can benefit from the advantages provided by the photonic integrated circuit according to the present invention.

### BRIEF DESCRIPTION OF THE DRAWINGS

Further features and advantages of the invention will become apparent from the description of exemplary and non-limiting embodiments of a photonic integrated circuit, an opto-electronic assembly and an opto-electronic system according to the present invention.

The person skilled in the art will appreciate that the described embodiments of the photonic integrated circuit, the opto-electronic assembly and the opto-electronic system are exemplary in nature only and not to be construed as limiting the scope of protection in any way. The person skilled in the art will realize that alternatives and equivalent embodiments of the photonic integrated circuit, the opto-electronic assembly and the opto-electronic system can be conceived and reduced to practice without departing from the scope of protection of the present invention.

Reference will be made to the figures on the accompanying drawing sheets. The figures are schematic in nature and therefore not necessarily drawn to scale. Furthermore, equal reference numerals denote equal or similar parts. On the attached drawing sheets,
figure 1 shows a schematic top view of a portion of a first exemplary, non-limiting embodiment of a photonic integrated circuit according to the present invention;
figure 2 shows a schematic top view of a portion of a second exemplary, non-limiting embodiment of the photonic integrated circuit according to the present invention;
figure 3 shows a schematic top view of a portion of a third exemplary, non-limiting embodiment of the photonic integrated circuit according to the present invention;
figure 4 shows a schematic top view of a portion of a fourth exemplary, non-limiting embodiment of the photonic integrated circuit according to the present invention;
figure 5 shows a schematic top view of a portion of a fifth exemplary, non-limiting embodiment of the photonic integrated circuit according to the present invention;
figure 6 shows a schematic top view of a portion of a sixth exemplary, non-limiting embodiment of the photonic integrated circuit according to the present invention;
figure 7 shows a schematic cross-section of the portion of the first exemplary, non-limiting embodiment of the photonic integrated circuit shown in figure 1;
figure 8 shows a schematic cross-section of the portion of the second exemplary, non-limiting embodiment of the photonic integrated circuit shown in figure 2;
figure 9 shows a schematic cross-section of a portion of a first exemplary, non-limiting embodiment of an opto-electronic assembly according to the present invention that comprises a photonic integrated circuit in accordance with the first exemplary, non-limiting embodiment shown in figure 7 and a first exemplary, non-limiting embodiment of an electronic integrated circuit;
figure 10 shows a schematic cross-section of a portion of a second exemplary, non-limiting embodiment of an opto-electronic assembly according to the present invention that comprises a photonic integrated circuit in accordance with the first exemplary, non-limiting embodiment shown in figures 7 and 9, and the first exemplary, non-limiting embodiment of an electronic integrated circuit shown in figure 9;
figure 11 shows a schematic cross-section of a portion of a third exemplary, non-limiting embodiment of an opto-electronic assembly according to the present invention that comprises a photonic integrated circuit in accordance with the first exemplary, non-limiting embodiment shown in figures 7, 9 and 10, and the first exemplary, non-limiting embodiment of an electronic integrated circuit shown in figures 9 and 10;
figure 12 shows a schematic cross-section of a portion of a fourth exemplary, non-limiting embodiment of an opto-electronic assembly according to the present invention that comprises a photonic integrated circuit in accordance with the first exemplary, non-limiting embodiment shown in figures 7, 9, 10 and 11, and the first exemplary, non-limiting embodiment of an electronic integrated circuit shown in figures 9, 10 and 11;
figure 13 shows a schematic cross-section of a portion of a fifth exemplary, non-limiting embodiment of the opto-electronic assembly according to the present invention that comprises a photonic integrated circuit in accordance with the second exemplary, non-limiting embodiment shown in figure 8 and the first exemplary, non-limiting embodiment of the electronic integrated circuit shown in figures 9,10, 11 and 12;
figure 14 shows a schematic top view of a portion of the first exemplary, non-limiting embodiment of the opto-electronic assembly shown in figure 9; and
figure 15 shows a schematic top view of a first exemplary, non-limiting embodiment of an opto-electronic system according to the present invention that comprises a photonic integrated circuit and an opto-electronic assembly according to the present invention.

### DETAILED DESCRIPTION OF EMBODIMENTS

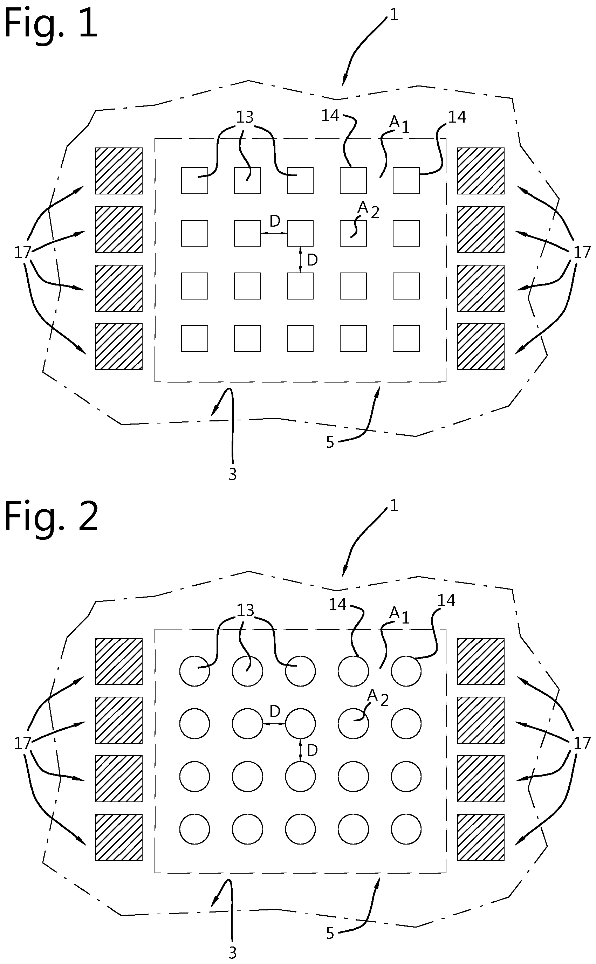

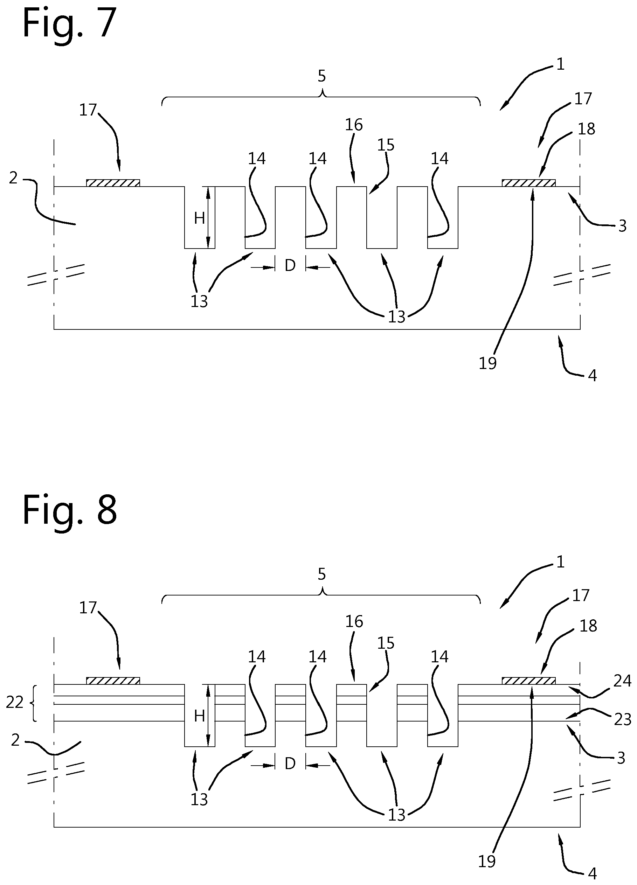

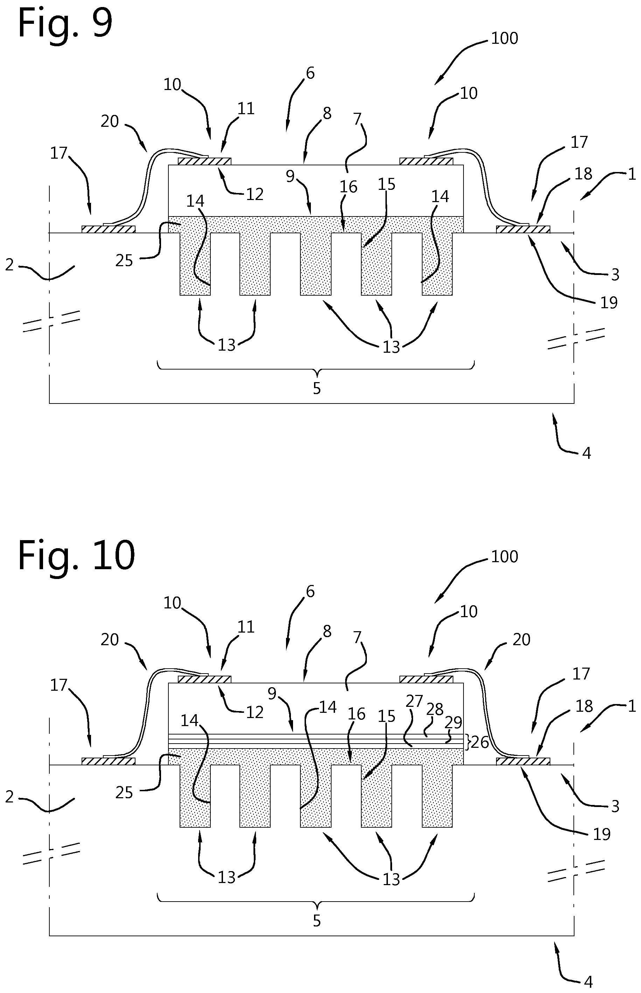

Figure 1 shows a schematic top view of a portion of a first exemplary, non-limiting embodiment of a photonic integrated circuit 1 according to the present invention comprising a semiconductor-based substrate having a first side 3 that is provided with a placeholder area 5 for allowing association of the photonic integrated circuit 1 with an electronic integrated circuit 6 that comprises a first set of electrically conductive contact pads 10 as shown in figures 9, 10, 11, 12, 13 and 14. The placeholder area 5 has a first surface area *A*₁ that is in a first range between 0.05mm² and 10mm². In the placeholder area 5, the semiconductor-based substrate of the photonic integrated circuit 1 is provided with a set of recessed surfaces 13. A respective recessed surface of the set of recessed surfaces 13 is arranged parallel to the second side 4 of the semiconductor-based substrate 2 as is for example shown in figures 7, 8, 9, 10, 11, 12 and 13. A respective recessed surface of the set of recessed surfaces 13 has a second surface area, *A*₂, that is in a second range between 100µm² and 10,000µm². Neighboring recessed surfaces of the set of recessed surfaces 13 are arranged at a distance, D, from each other as seen in a direction parallel to the second side 4 of the semiconductor-based substrate 2. The distance, D, is in a third range between 1µm and 100µm. In addition, a respective recessed surface of the set of recessed surfaces 13 is enclosed by a respective side wall 14 comprising semiconductor-based material. As is for example shown in figures 7, 8, 9, 10, 11, 12 and 13, a respective side wall 14 has an end portion 15 comprising a seventh side 16 that is arranged parallel to the second side 4 of the semiconductor-based substrate 2 of the photonic integrated circuit 1 at a height, H, from the respective recessed surface 13 as seen in a direction transverse to the second side 4 of the semiconductor-based substrate 2.

In accordance with the first exemplary, non-limiting embodiment of the photonic integrated circuit 1 according to the present invention, the photonic integrated circuit 1 comprises a second set of electrically conductive contact pads 17 that are configured and arranged relative to the set of recessed surfaces 13 to allow, if the electronic integrated circuit is associated with the placeholder area 5, establishment of electrical connections between electrically conductive contact pads of the first set of electrically conductive contact pads 10 and electrically conductive contact pads of the second set of electrically conductive contact pads 17 using at least one of wires 20 of electrically conducting material and ribbons 21 of electrically conducting material as shown in figures 9, 10, 11, 12, 13 and 14.

As shown in figures 1, 2, 3, 4, 5 and 6 regarding the first, second, third, fourth, fifth and sixth exemplary, non-limiting embodiments of the photonic integrated circuit 1 respectively, the set of recessed surfaces 13 can have any suitable number of recessed surfaces for establishing a placeholder area 5 that is suitable for allowing association of a desired electronic integrated circuit with the photonic integrated circuit 1.

The placeholder area or docking pad 5 shown in figures 1 to 6 has a perimeter that has a rectangular shape. However, the placeholder area can have any suitable shape, for example another polygonal shape, e.g. square (not shown), L-shaped (not shown) or T-shaped (not shown), an elliptical shape (not shown), e.g. circular or oval or a composite shape (not shown), i.e. a combination of connected straight perimeter parts and curved perimeter parts. In this way, it is possible to adapt the perimeter of the placeholder area to a perimeter of the electronic integrated circuit that is to be accommodated.

In accordance with the first exemplary, non-limiting embodiment of the photonic integrated circuit 1 according to the present invention shown in figure 1, the respective recessed surfaces of the set of recessed surfaces 13 are enclosed by respective side walls 14 having square-shaped perimeters. However, the perimeters of the respective side walls 14 can have any suitable shape, for example another polygonal shape, e.g. rectangular (not shown), L-shaped (not shown) or T-shaped (not shown), a circular shape as shown in figures 2 to 6, another elliptical shape, e.g. oval (not shown) or a composite shape (not shown), i.e. a combination of connected straight perimeter parts and curved perimeter parts for achieving reliable support of the electronic integrated circuit.

Although not shown, it is possible that perimeters of some side walls enclosing recessed surfaces of a first subset of the set of recessed surfaces have for example a polygonal shape and other side walls enclosing recessed surfaces of a second subset of the set of recessed surfaces have for example an elliptical shape or a composite shape.

Although not shown, it is possible that, if an electronic integrated circuit is associated with the placeholder area or docking pad of the photonic integrated circuit according to the invention, at least a number of side walls enclosing recessed surfaces of the first subset of the set of recessed surfaces having a polygonal-shaped perimeter and/or at least a number of side walls enclosing recessed surfaces of the second subset of the set of recessed surfaces having for example an elliptical shape or a composite shape are associated with the electronic integrated circuit.

It is noted that the number of recessed surfaces of the first subset of the set of recessed surfaces can be any number that is sufficient to allow a secure association of the electronic integrated circuit with the placeholder area or docking pad of the photonic integrated circuit. The same holds for the number of recessed surfaces of the second subset of the set of recessed surfaces.

Furthermore, it is noted that a sum of the number of recessed surfaces of the first subset of the set of recessed surfaces and the number of recessed surfaces of the second subset of the set of recessed surfaces can be smaller than or equal to the number of recessed surfaces of the complete set of recessed surfaces. It is possible that the number of recessed surfaces of the first subset of the set of recessed surfaces or the number of recessed surfaces of the second subset of recessed surfaces is equal to the number of recessed surfaces of the complete set of recessed surfaces. In such event, the first subset of the set of recessed surfaces or the second subset of the set of recessed surfaces is an empty subset.

As shown in figures 1, 2 and 3 regarding the first, second and third exemplary, non-limiting embodiments of the photonic integrated circuit 1 respectively, the distance D between neighboring recessed surfaces of the set of recessed surfaces 13 can have a specific value in the above-mentioned third range between 1µm and 100µm and the second surface area *A*₂ of all recessed surfaces of the set of recessed surfaces 13 can have a specific value in the above-mentioned second range between 100µm² and 10,000µm². Such a uniform distribution of the recessed surfaces over the placeholder area or docking pad 5 can be advantageous for reducing and preferably minimizing at least one of variations in etch loading and photoresist pooling in order to achieve an improved yield and/or reliability of the photonic integrated circuit 1.

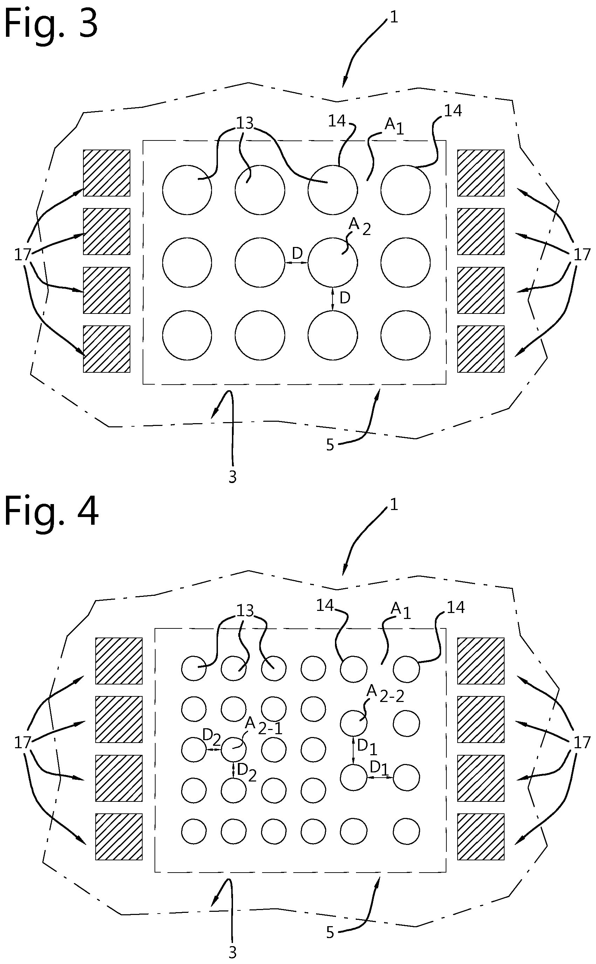

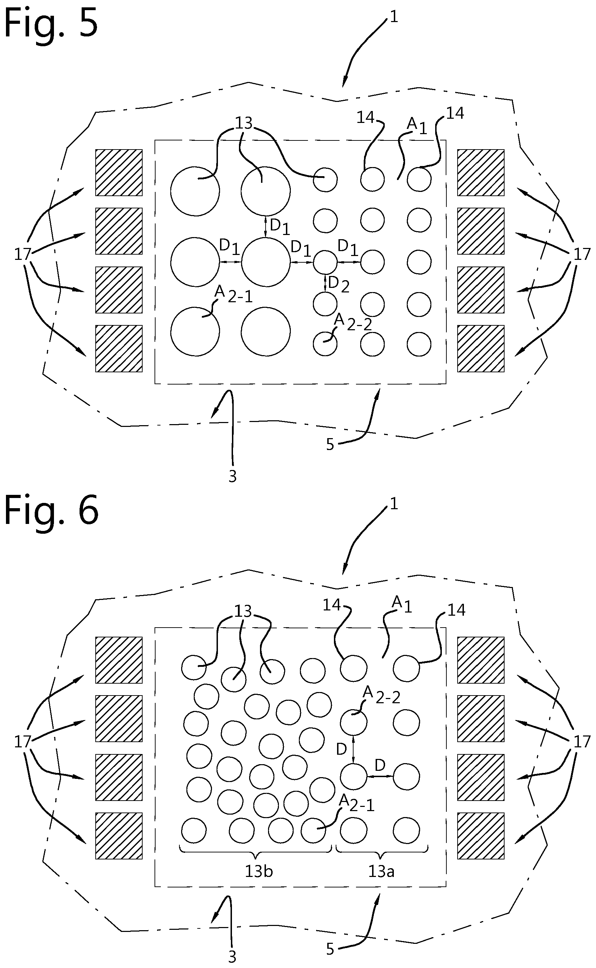

As shown in figures 4 and 5 regarding the fourth and fifth exemplary, non-limiting embodiments of the photonic integrated circuit 1 respectively, it is noted that as the distance between some recessed surfaces of the set of recessed surfaces 13 can have a first value *D*₁, which is in the above-mentioned third range, and between other recessed surfaces of the set of recessed surfaces 13 a second value *D*₂, which is in the above-mentioned third range, the recessed surfaces of the set of recessed surfaces 13 can be distributed over the placeholder area or docking pad 5 in any suitable way depending on the requirements regarding reduced and preferably minimized variations in etch loading and/or reduced and preferably minimized photoresist pooling.

Regarding the fifth exemplary, non-limiting embodiment of the photonic integrated circuit 1 shown in figure 5, it is noted that the distance between neighboring recessed surfaces of the set of recessed surfaces 13 in a horizontal direction can have a first value *D*₁, which is in the above-mentioned third range, whereas the distance between these recessed surfaces in a vertical direction has a second value *D*₂, which is in the above-mentioned third range. In this way, an additional degree of freedom is provided for distributing the recessed surfaces of the set of recessed surfaces 13 over the placeholder area or docking pad 5 in a suitable way depending on the requirements regarding reduced and preferably minimized variations in etch loading and/or reduced and preferably minimized photoresist pooling.

Regarding the sixth exemplary, non-limiting embodiment of the photonic integrated circuit 1 shown in figure 6, it is noted that the placeholder area or docking pad 5 has a first region in which a first subset 13a of recessed surfaces of the set of recessed surfaces 13 are uniformly distributed at a distance D relative to each other, and a second region in which a second subset 13b of recessed surfaces of the set of recessed surfaces 13 are non-uniformly distributed. In this way, an additional degree of freedom is provided for reducing at least one of variations in etch loading and photoresist pooling during fabrication of the photonic integrated circuit according to the present invention.

As shown in figures 4, 5 and 6 regarding the fourth, fifth and sixth exemplary, non-limiting embodiments of the photonic integrated circuit 1 respectively, the second surface area of recessed surfaces of the second subset 13b of recessed surfaces of the set of recessed surfaces 13 has a first value *A*_{2_1}, which is in the above-mentioned second range, and the second surface area of recessed surfaces of the first subset 13a of recessed surfaces the set of recessed surfaces 13 has a second value *A*_{2_2}, which is in the above-mentioned second range in order to distribute the recessed surfaces of the set of recessed surfaces 13 over the placeholder area or docking pad 5 in a suitable way to meet requirements regarding reduced and preferably minimized variations in etch loading and/or reduced and preferably minimized photoresist pooling. Based on the foregoing it is clear that the configurability of the placeholder area or docking pad 5 can improve the robustness of the fabrication process and consequently the yield and/or reliability of the photonic integrated circuit 1 according to the present invention.

It is noted that contrary to what is shown in figures 4, 5 and 6 regarding the fourth, fifth and sixth exemplary, non-limiting embodiments of the photonic integrated circuit 1 respectively, it is possible that all recessed surfaces of the set of recessed surfaces 13 have the same second surface area *A*₂ with a value in the above-mentioned second range.

Figure 7 shows a schematic cross-section of the portion of the first exemplary, non-limiting embodiment of the photonic integrated circuit 1 shown in figure 1. Figure 7 shows that the photonic integrated circuit 1 comprises a substrate 2 that has a first side 3 and a second side 4. The first side 3 and the second side 4 are arranged parallel to each other and facing away from each other. In the placeholder area 5, the first side 3 of the semiconductor-based substrate 2 is provided with the set of recessed surfaces 13. A respective recessed surface of the set of recessed surfaces 13 is arranged parallel to the second side 4 of the semiconductor-based substrate 2. Neighboring recessed surfaces of the set of recessed surfaces 13 are arranged at a distance, D, from each other as seen in a direction parallel to the second side 4 of the semiconductor-based substrate 2. As mentioned above, the distance, D, is in a third range between 1µm and 100µm. In addition, a respective recessed surface of the set of recessed surfaces 13 is enclosed by a respective side wall 14 that comprises semiconductor-based material and has an end portion 15 comprising a seventh side 16 that is arranged parallel to the second side 4 of the semiconductor-based substrate 2 at a height, H, above the respective recessed surface 13 as seen in a direction transverse to the second side 4 of the semiconductor-based substrate 2. The height H is in a fourth range between 1µm and 10µm. A value for the height H in the fourth range provides an additional degree of freedom for reducing at least one of variations in etch loading and photoresist pooling during fabrication of the photonic integrated circuit.

The seventh side 16 has a second surface area *A*₂ that is in a second range between 100µm² and 10,000µm². Furthermore, each recessed surface of the set of recessed surfaces 13 is arranged at a distance D from a neighboring recessed surface of the set of recessed surfaces 13 as seen in a direction parallel to the second side 4 of the semiconductor-based substrate 2. The distance D is in a third range between 1µm and 100µm.

It is noted that the shape of the respective semiconductor-based side walls 14 shown in figures 7 to 13 is schematic in nature. In practice, the respective semiconductor-based side walls 14 can have any suitable shape, e.g. slightly sloped or tapering, as long as the semiconductor-based side walls 14 have sufficient mechanical strength for providing reliable support of an electronic integrated circuit.

Figure 7 furthermore shows that the first side 3 of the semiconductor-based substrate 2 is provided with a second set of electrically conductive contact pads 17. In accordance with the first exemplary, non-limiting embodiment of the photonic integrated circuit 1 shown in figure 7, the electrically conductive contact pads of the second set of electrically conductive contact pads 17 are accessible at the first side 3 of the semiconductor-based substrate 2. Each electrically conductive contact pad of the second set of electrically conductive contact pads 17 has an eighth side 18 and a ninth side 19. The ninth side 19 is arranged in contact with the first side 3 of the semiconductor-based substrate 2 and the eighth side 18 is arranged facing away from the first side 3 of the semiconductor-based substrate 2. The second set of electrically conductive contact pads 17 is configured and arranged relative to the placeholder area 5 to allow, if an electronic integrated circuit (not shown) is associated with the placeholder area 5, establishment of electrical connections between the photonic integrated circuit 1 and the electronic integrated circuit (not shown).

In accordance with the first exemplary, non-limiting embodiment of the photonic integrated circuit 1 shown in figure 7, the substrate 2 comprises InP-based material and the respective side walls 14 that are arranged to enclose the respective recessed surfaces of the set of recessed surfaces 13 comprise InP-based material that can be associated with an electronic integrated circuit (not shown) that is to be associated with the photonic integrated circuit 1. It is noted that the InP-based side walls 14 have sufficient mechanical strength for providing reliable support of the electronic integrated circuit. In addition, the InP-based side walls 14 allow good adhesion of an adhesive material, such as an epoxy resin, for reliably gluing the InP-based side walls 14 in the placeholder area or docking pad 5 and the electronic circuit (not shown) together.

Figure 8 shows a schematic cross-section of the portion of the second exemplary, non-limiting embodiment of the photonic integrated circuit 1 shown in figure 2. The photonic integrated circuit 1 shown in figure 8 comprises a semiconductor-based substrate 2 comprising InP-based material and a layer stack 22 of three epitaxial semiconductor-based layers. It is noted that any suitable number of epitaxial semiconductor-based layers of any suitable composition and any suitable dimensions can be envisaged. The three epitaxial semiconductor-based layers of the layer stack 22 can be configured to provide optical functionality if the photonic integrated circuit 1 is in use. The layer stack 22 of three epitaxial semiconductor-based layers has a tenth side 23 and an eleventh side 24 that are arranged parallel to each other and facing away from each other. The tenth side 23 is arranged in contact with the first side 3 of the semiconductor-based substrate 2. The respective side walls 14 that are arranged to enclose the respective recessed surfaces of the set of recessed surfaces 13 comprise InP-based material of the semiconductor-based substrate 2 and semiconductor-based material of the three epitaxial semiconductor-based layers of the layer stack 22. It is noted that the semiconductor-based substrate 2 can comprise any semiconductor material that allows the semiconductor-based layers of the layer stack 22 to be epitaxially grown on the first side 3 of the semiconductor-based substrate 2. The epitaxial semiconductor-based layers of the layer stack 22 can comprise for example epitaxial material comprising at least one of Indium (In), Gallium (Ga), Aluminum (Al), Phosphorus (P) and Arsenic (As). The epitaxial semiconductor-based layers of the layer stack 22 can be associated with an electronic integrated circuit (not shown) that is to be associated with the photonic integrated circuit 1.

Figure 9 shows a schematic cross-section of a portion of a first exemplary, non-limiting embodiment of an opto-electronic assembly 100 according to the present invention. The opto-electronic assembly 100 comprises a photonic integrated circuit 1 in accordance with the first exemplary, non-limiting embodiment shown in figure 7 and a first exemplary, non-limiting embodiment of an electronic integrated circuit 6 that comprises a substrate 7 comprising a third side 8 and a fourth side 9. The third side 8 and the fourth side 9 are arranged parallel to each other and facing away from each other. The fourth side 9 of the substrate 7 being associated with the placeholder area 5 at the first side 3 of the semiconductor-based substrate 2 of the photonic integrated circuit 1. The substrate 7 being provided with a first set of electrically conductive contact pads 10. In accordance with the first exemplary, non-limiting embodiment of the opto-electronic assembly 100 shown in figure 7, the electrically conductive contact pads of the first set of electrically conductive contact pads 10 are accessible at the third side 8 of the substrate 7. Each electrically conductive contact pad of the first set of electrically conductive contact pads 10 has a fifth side 11 and a sixth side 12. The sixth side 12 is associated with the third side 8 of the substrate 7 of the electronic integrated circuit 6 and the fifth side 11 is arranged facing away from the first side 3 of the semiconductor-based substrate 2 of the photonic integrated circuit 1. In accordance with the first exemplary, non-limiting embodiment of the opto-electronic assembly 100 shown in figure 7, the fifth sides 11 of the electrically conductive contact pads of the first set of electrically conductive contact pads 10 of the electronic integrated circuit 6 and the eighth sides 18 of the electrically conductive contact pads of the second set of electrically conductive contact pads 17 of the photonic integrated circuit 1 are electrically interconnected via wires 20 of electrically conducting material. This is possible because the electrically conductive contact pads of the second set of electrically conductive contact pads 17 of the photonic integrated circuit 1 and the electrically conductive contact pads of the first set of electrically conductive contact pads 10 of the electronic integrated circuit 6 are not facing towards each other. This arrangement of the electronic integrated circuit 6 and the photonic integrated circuit 1 relative to each other can be referred to as a back-to-face arrangement, i.e. the fourth side 9 or backside of the substrate 7 of the electronic integrated circuit 6 and the first side 3 or face of the semiconductor-based substrate 2 of the photonic integrated circuit 1 are arranged facing towards each other.

In accordance with another exemplary, non-limiting embodiment of the opto-electronic assembly (not shown), the fifth sides of the electrically conductive contact pads of the first set of electrically conductive contact pads of the electronic integrated circuit and the eighth sides of the electrically conductive contact pads of the second set of electrically conductive contact pads of the photonic integrated circuit can be electrically interconnected via ribbons of electrically conducting material.

In accordance with the first exemplary, non-limiting embodiment of the opto-electronic assembly 100 shown in figure 7, the electronic integrated circuit 6 is associated with the photonic integrated circuit 1 via an adhesive material 25. The adhesive material 25 is arranged in direct contact with the first side 3 of the semiconductor-based substrate 2, the respective recessed surfaces of the set of recessed surfaces 13 and the seventh sides 16 of the end portions 15 of the respective side walls 14 that are arranged to enclose the respective recessed surfaces of the set of recessed surfaces 13 in the placeholder area or docking pad 5 of the photonic integrated circuit 1, and the fourth side 9 of the substrate 7 of the electronic integrated circuit 6. The adhesive material 25 can be of any type, for example an epoxy resin, suitable for reliably gluing the photonic integrated circuit 1 and the electronic integrated circuit 6 together.

Figure 10 shows a schematic cross-section of a portion of a second exemplary, non-limiting embodiment of an opto-electronic assembly 100 according to the present invention that comprises a photonic integrated circuit 1 in accordance with the first exemplary, non-limiting embodiment shown in figures 7 and 9, and the first exemplary, non-limiting embodiment of an electronic integrated circuit shown in figure 9. The electronic integrated circuit 6 is associated with the photonic integrated circuit 1 via the adhesive material 25. The adhesive material 25 is arranged in direct contact with the first side 3 of the semiconductor-based substrate 2, the respective recessed surfaces of the set of recessed surfaces 13 and the seventh sides 16 of the end portions 15 of the respective side walls 14 that are arranged to enclose the respective recessed surfaces of the set of recessed surfaces 13 in the placeholder area or docking pad 5 of the photonic integrated circuit 1, and a first intermediate medium 26 that is arranged in direct contact with the fourth side 9 of the substrate 7 of the electronic integrated circuit 6.

The first intermediate medium 26 can be used for at least one of planarization, environmental protection and adhesion enhancement purposes. Depending on the specific purpose, the first intermediate medium 26 can comprise any suitable number of layers. In accordance with the second exemplary, non-limiting embodiment of the opto-electronic assembly 100 shown in figure 10, the first intermediate medium 26 comprises three layers, i.e. a polymer layer 27, a dielectric layer 28 and a metal layer 29.

The dielectric layer 28 is arranged in direct contact with both the metal layer 29 and the fourth side 9 of the substrate 7 of the electronic integrated circuit 6. The polymer layer 27 is arranged in direct contact with both the metal layer 29 and the adhesive material 25. The polymer layer 27 can comprise any suitable material, such as benzocyclobutene (BCB), allowing reliable mechanical connections with both the adhesive material 25 and the metal layer 29. The dielectric layer 28 can comprise any suitable material, such as silicon nitride (SiNₓ), silicon oxide (SiOₓ), silicon oxynitride (SiONₓ), allowing reliable mechanical connections with both the metal layer 29 and the fourth side 9 of the substrate 7 of the electronic integrated circuit 6. The metal layer 29 can comprise any suitable material, such as gold (Au). It is noted that the metal layer 29 is not applied for establishing or facilitating any kind of electrical interaction or connection between the electronic integrated circuit 6 and the photonic integrated circuit 1. The metal layer 29 can be used for electrical functionality such as routing of electrical signals across the electronic integrated circuit 6.

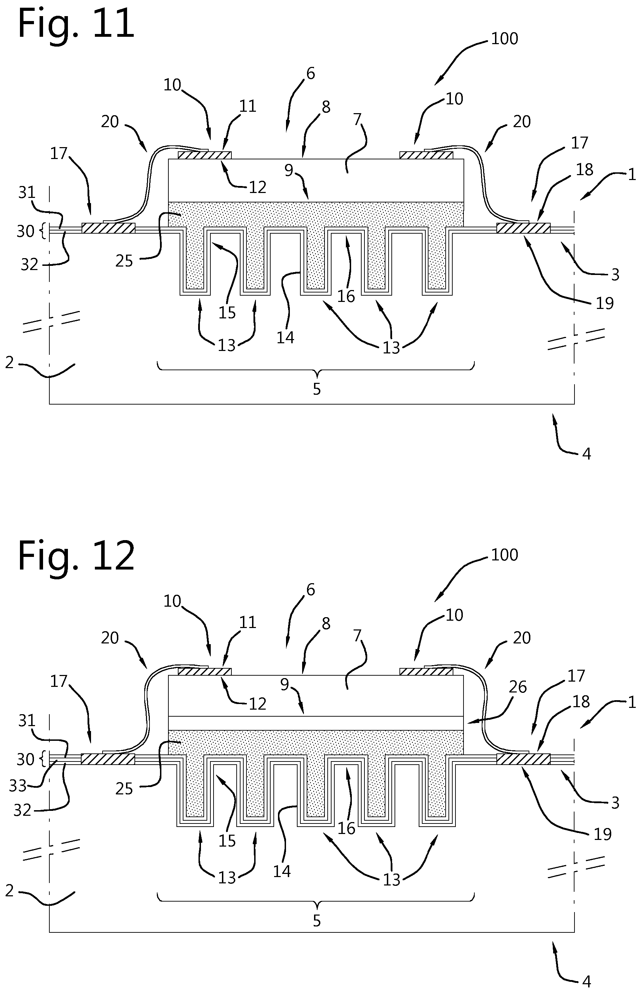

Figure 11 shows a schematic cross-section of a portion of a third exemplary, non-limiting embodiment of an opto-electronic assembly 100 according to the present invention that comprises a photonic integrated circuit 1 in accordance with the first exemplary, non-limiting embodiment shown in figures 7, 9 and 10, and the first exemplary, non-limiting embodiment of an electronic integrated circuit 6 shown in figures 9 and 10. The electronic integrated circuit 6 is associated with the photonic integrated circuit 1 via the adhesive material 25. The adhesive material 25 is arranged in direct contact with both the fourth side 9 of the substrate 7 of the electronic integrated circuit 6 and a second intermediate medium 30 that is arranged in direct contact with the first side 3 of the semiconductor-based substrate 2, the respective recessed surfaces of the set of recessed surfaces 13 and the seventh sides 16 of the end portions 15 of the respective side walls 14 that are arranged to enclose the respective recessed surfaces of the set of recessed surfaces 13 in the placeholder area or docking pad 5 of the photonic integrated circuit 1.

Although not shown in figure 11, it is possible that the adhesive material is arranged in contact with a seventh side of an end portion of a first side wall that is arranged to enclose a first recessed surface of the set of recessed surfaces and with a second intermediate medium that is arranged in contact with a seventh side of an end portion of a second side wall that is arranged to enclose a second recessed surface of the set of recessed surfaces. The first recessed surface and the second recessed surface can be neighboring recessed surfaces of the set of recessed surfaces in the placeholder area of the photonic integrated circuit according to the invention.

The second intermediate medium 30 can be used for at least one of planarization, environmental protection and adhesion enhancement purposes. Depending on the specific purpose, the second intermediate medium 30 can comprise any suitable number of layers. In accordance with the third exemplary, non-limiting embodiment of the opto-electronic assembly 100 shown in figure 11, the second intermediate medium 30 comprises two layers, i.e. a polymer layer 31 and a dielectric layer 32.

The dielectric layer 32 is arranged in direct contact with both the polymer layer 31 and the first side 3 of the semiconductor-based substrate 2, the respective recessed surfaces of the set of recessed surfaces 13 and the seventh sides 16 of the end portions 15 of the respective side walls 14 that are arranged to enclose the respective recessed surfaces of the set of recessed surfaces 13 in the placeholder area or docking pad 5 of the photonic integrated circuit 1. The polymer layer 31 is arranged in direct contact with both the dielectric layer 32 and the adhesive material 25. The polymer layer 31 can comprise any suitable material, such as BCB, allowing reliable mechanical connections with both the adhesive material 25 and the dielectric layer 32. The dielectric layer 32 can comprise any suitable material, such as SiNₓ, SiOₓ, or SiONₓ, allowing reliable mechanical connections with both the polymer layer 31 and the first side 3 of the semiconductor-based substrate 2, the respective recessed surfaces of the set of recessed surfaces 13 and the seventh sides 16 of the end portions 15 of the respective side walls 14 that are arranged to enclose the respective recessed surfaces of the set of recessed surfaces 13 in the placeholder area or docking pad 5 of the photonic integrated circuit 1.

Figure 12 shows a schematic cross-section of a portion of a fourth exemplary, non-limiting embodiment of an opto-electronic assembly 100 according to the present invention that comprises a photonic integrated circuit 1 in accordance with the first exemplary, non-limiting embodiment shown in figures 7, 9, 10 and 11, and the first exemplary, non-limiting embodiment of an electronic integrated circuit 6 shown in figures 9, 10 and 11. The electronic integrated circuit 6 is associated with the photonic integrated circuit 1 via the adhesive material 25. The adhesive material 25 is arranged in direct contact with both the first intermediate medium 26, which is arranged in contact with the fourth side 9 of the substrate 7 of the electronic integrated circuit 6, and the second intermediate medium 30 that is arranged in direct contact with the first side 3 of the semiconductor-based substrate 2, the respective recessed surfaces of the set of recessed surfaces 13 and the seventh sides 16 of the end portions 15 of the respective side walls 14 that are arranged to enclose the respective recessed surfaces of the set of recessed surfaces 13 in the placeholder area or docking pad 5 of the photonic integrated circuit 1.

Although not shown in figure 12, it is possible that the adhesive material is arranged in contact with a seventh side of an end portion of a first side wall that is arranged to enclose a first recessed surface of the set of recessed surfaces and with a second intermediate medium that is arranged in contact with a seventh side of an end portion of a second side wall that is arranged to enclose a second recessed surface of the set of recessed surfaces. The first recessed surface and the second recessed surface can be neighboring recessed surfaces of the set of recessed surfaces in the placeholder area of the photonic integrated circuit according to the invention.

At least one of the first intermediate medium 26 and the second intermediate medium 30 can be used for at least one of planarization, environmental protection and adhesion enhancement purposes. Depending on the specific purpose, the first intermediate medium 26 and the second intermediate medium 30 can comprise any suitable number of layers. In accordance with the fourth exemplary, non-limiting embodiment of the opto-electronic assembly 100 shown in figure 12, the first intermediate medium 26 is a single layer comprising any suitable polymer material, such as BCB, or any suitable dielectric material, such as SiNₓ, SiOₓ, or SiONₓ. The first intermediate medium 26 is arranged in direct contact with the adhesive material 25 and the fourth side 9 of the substrate 7 of the electronic integrated circuit 6 allowing reliable mechanical connections with both the adhesive material 25 and the fourth side 9 of the substrate 7 of the electronic integrated circuit 6.

Furthermore, in accordance with the fourth exemplary, non-limiting embodiment of the opto-electronic assembly 100 shown in figure 12, the second intermediate medium 30 comprises three layers, i.e. a polymer layer 31, a dielectric layer 32, and a metal layer 33. The dielectric layer 32 is arranged in direct contact with both the metal layer 33 and the first side 3 of the semiconductor-based substrate 2, the respective recessed surfaces of the set of recessed surfaces 13 and the seventh sides 16 of the end portions 15 of the respective side walls 14 that are arranged to enclose the respective recessed surfaces of the set of recessed surfaces 13 in the placeholder area or docking pad 5 of the photonic integrated circuit 1. The dielectric layer 32 can comprise any suitable material, such as SiNₓ, SiOₓ or SiONₓ, allowing reliable mechanical connections with both the metal layer 33 and the first side 3 of the semiconductor-based substrate 2, the respective recessed surfaces of the set of recessed surfaces 13 and the seventh sides 16 of the end portions 15 of the respective side walls 14 that are arranged to enclose the respective recessed surfaces of the set of recessed surfaces 13 in the placeholder area or docking pad 5 of the photonic integrated circuit 1. The polymer layer 31 is arranged in direct contact with both the metal layer 33 and the adhesive material 25. The polymer layer 31 can comprise any suitable material, such as BCB, allowing reliable mechanical connections with both the metal layer 33 and the adhesive material 25. The metal layer 33 can comprise any suitable material, such as Au. It is noted that the metal layer 33 is not applied for establishing or facilitating any kind of electrical interaction or connection between the electronic integrated circuit 6 and the photonic integrated circuit 1. The metal layer 33 can be used for electrical functionality such as routing of electrical signals across the electronic integrated circuit 6.

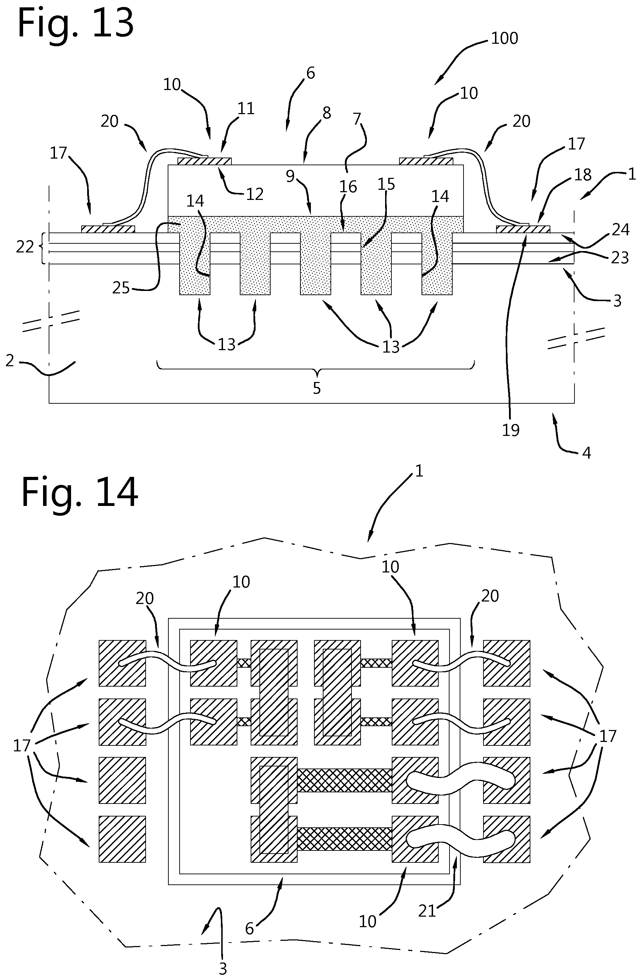

Figure 13 shows a schematic cross-section of a portion of a fifth exemplary, non-limiting embodiment of the opto-electronic assembly 100 according to the present invention that comprises a photonic integrated circuit 1 in accordance with the second exemplary, non-limiting embodiment shown in figure 8 and the first exemplary, non-limiting embodiment of the electronic integrated circuit shown in figures 9, 10, 11 and 12. The electronic integrated circuit 6 is associated with the photonic integrated circuit 1 via an adhesive material 25. The adhesive material 25 is arranged in direct contact with both the fourth side 9 of the substrate 7 of the electronic integrated circuit 6, the epitaxial semiconductor material of the layer stack 22 of three epitaxial semiconductor-based layers and the respective recessed surfaces of the set of recessed surfaces 13. The adhesive material 25, such as an epoxy resin, allows establishing a reliable mechanical connection between the electronic integrated circuit 6 and the photonic integrated circuit 1.

Although not shown in figure 13, it is noted that it is possible to apply at least one of the first intermediate medium and the second intermediate medium in similar ways as is shown in figures 10, 11 and 12.

Figure 14 shows a schematic top view of a portion of the first exemplary, non-limiting embodiment of the opto-electronic assembly 100 shown in figure 9. Wires 20 of electrically conductive material and ribbons 21 of electrically conductive material are used to provide electrical connections between electrically conductive contact pads of the first set of electrically conductive contact pads 10 of the electronic integrated circuit 6 and electrically conductive contact pads of the second set of electrically conductive contact pads 17 of the photonic integrated circuit 1.

The electrically conducting material of the wires 20 and the electrically conducting material of the ribbons 21 can comprise metal. Any suitable metal, e.g. gold, copper, aluminum, metal alloy, e.g. gold-aluminum or gold-palladium, plated metal, e.g. gold-plated copper or gold-plated silver, or coated metal, e.g. palladium coated copper can be used provided that it at least has good electrical conductivity and is compatible with wire bonding and/or ribbon bonding processes.

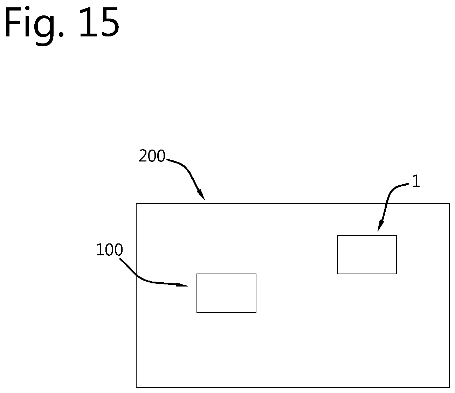

Figure 15 shows a schematic view of a first exemplary, non-limiting embodiment of an opto-electronic system 200 according to the present invention that comprises a photonic integrated circuit 1 and an opto-electronic assembly 100 according to the present invention. The opto-electronic system 200 can be used for example but not exclusively in telecommunication applications, LIDAR or sensor applications. The opto-electronic system 200 can for example be one of a transmitter, a receiver, a transceiver, a coherent transmitter, a coherent receiver and a coherent transceiver. Based on the above, the person skilled in the art will appreciate that the opto-electronic system 200 according to the present invention can benefit from the advantages provided by the photonic integrated circuit 1 and the opto-electronic assembly 100 according to the present invention.

The present invention can be summarized as relating to a photonic integrated circuit 1 for hybrid integration with an electronic integrated circuit 6 that comprises a first set of electrically conductive contact pads 10. The photonic integrated circuit comprises a set of recessed surfaces 13 providing a placeholder area or docking pad 5 with which the electronic integrated circuit can be associated via an adhesive material 25. The placeholder area or docking pad is surrounded by a second set of electrically conductive contact pads 17. If the electronic integrated circuit and the photonic integrated circuit are glued together via the adhesive material, electrical connections between the first set of electrically conductive contact pads and the second set of electrically conductive contact pads can be established using wires 20 and/or ribbons 21 of electrically conducting material. The invention also relates to an opto-electronic assembly 100 and an opto-electronic system 200 comprising said photonic integrated circuit.

It will be clear to a person skilled in the art that the scope of the present invention is not limited to the examples discussed in the foregoing but that several amendments and modifications thereof are possible without deviating from the scope of the present invention as defined by the attached claims. In particular, combinations of specific features of various aspects of the invention may be made. An aspect of the invention may be further advantageously enhanced by adding a feature that was described in relation to another aspect of the invention. While the present invention has been illustrated and described in detail in the figures and the description, such illustration and description are to be considered illustrative or exemplary only, and not restrictive.

The present invention is not limited to the disclosed embodiments. Variations to the disclosed embodiments can be understood and effected by a person skilled in the art in practicing the claimed invention, from a study of the figures, the description and the attached claims. In the claims, the word "comprising" does not exclude other steps or elements, and the indefinite article "a" or "an" does not exclude a plurality. The mere fact that certain measures are recited in mutually different dependent claims does not indicate that a combination of these measures cannot be used to advantage. Any reference numerals in the claims should not be construed as limiting the scope of the present invention.

## Claims

1. A photonic integrated circuit (1) for hybrid integration with an electronic integrated circuit, the photonic integrated circuit (1) comprising:
- a semiconductor-based substrate (2) that comprises a first side (3) and a second side (4), the first side (3) and the second side (4) being arranged parallel to each other and facing away from each other, wherein the first side (3) of the semiconductor-based substrate (2) is provided with a placeholder area (5) for allowing association of the photonic integrated circuit (1) with an electronic integrated circuit that comprises a substrate having a third side and a fourth side, the third side and the fourth side being arranged parallel to each other and facing away from each other, the substrate being provided with a first set of electrically conductive contact pads, at least one electrically conductive contact pad of the first set of electrically conductive contact pads being accessible at the third side of the substrate or via the third side of the substrate, each electrically conductive contact pad of the first set of electrically conductive contact pads having a fifth side and a sixth side, the sixth side being associated with the substrate of the electronic integrated circuit and the fifth side being arranged facing away from the first side (3) of the semiconductor-based substrate (2) if the fourth side of the substrate of the electronic integrated circuit is associated with the placeholder area (5), the placeholder area (5) having a first surface area, *A*₁, that is in a first range between 0.05mm² and 10mm², and wherein the semiconductor-based substrate (2) in the placeholder area (5) is provided with a set of recessed surfaces (13), wherein a respective recessed surface of the set of recessed surfaces:
• is arranged parallel to the second side (4) of the semiconductor-based substrate (2);
• has a second surface area, *A*₂, that is in a second range between 100µm² and 10,000µm²;
• is arranged at a distance, D, from a neighboring recessed surface of the set of recessed surfaces as seen in a direction parallel to the second side (4) of the semiconductor-based substrate (2), the distance, D, being in a third range between 1µm and 100µm; and
• is enclosed by a respective side wall (14) comprising semiconductor-based material, the respective side wall (14) having an end portion (15) comprising a seventh side (16) that is arranged parallel to the second side (4) of the semiconductor-based substrate (2) at a height, H, from the respective recessed surface as seen in a direction transverse to the second side (4) of the semiconductor-based substrate (2); and
- a second set of electrically conductive contact pads (17), at least one electrically conductive contact pad of the second set of electrically conductive contact pads (17) being accessible at the first side (3) of the semiconductor-based substrate (2) or via the first side (3) of the semiconductor-based substrate (2), each electrically conductive contact pad of the second set of electrically conductive contact pads (17) having an eighth side (18) and a ninth side (19), the ninth side (19) being associated with the semiconductor-based substrate (2) and the eighth side (18) being arranged facing away from the first side (3) of the semiconductor-based substrate (2), the second set of electrically conductive contact pads (17) being configured and arranged relative to the placeholder area (5) to allow, if an electronic integrated circuit is associated with the placeholder area (5), establishment of electrical connections between fifth sides of electrically conductive contact pads of the first set of electrically conductive contact pads and eighth sides (18) of electrically conductive contact pads of the second set of electrically conductive contact pads (17) using at least one of wires of electrically conducting material and ribbons of electrically conducting material.

2. The photonic integrated circuit (1) according to claim 1, wherein the recessed surfaces of the set of recessed surfaces (13) are uniformly distributed or non-uniformly distributed over the placeholder area (5).

3. The photonic integrated circuit (1) according to claim 1, wherein the placeholder area (5) has a first region in which a first subset (13a) of recessed surfaces of the set of recessed surfaces (13) are uniformly distributed, and a second region in which a second subset (13b) of recessed surfaces of the set of recessed surfaces (13) are non-uniformly distributed.

4. The photonic integrated circuit (1) according to any one of the claims 1 to 3, wherein the height, *H*, is in a fourth range between 1µm and 10µm.

5. The photonic integrated circuit (1) according to any one of the claims 1 to 4, wherein the respective side wall (14) is arranged to provide the respective recessed surface of the set of recessed surfaces (13) that is enclosed by the respective side wall (14) with a perimeter having a polygonal shape or an elliptical shape.

6. The photonic integrated circuit (1) according to any one of the claims 1 to 4, wherein the respective side wall (14) is arranged to provide the respective recessed surface of the set of recessed surfaces (13) that is enclosed by the respective side wall (14) with a perimeter having a composite shape that comprises interconnected straight sections and curved sections.

7. The photonic integrated circuit (1) according to any one of the claims 1 to 6, wherein the semiconductor-based substrate (2) comprises InP-based material, and is associated with a layer stack (22) comprising at least one epitaxial semiconductor-based layer, the layer stack (22) having a tenth side (23) and an eleventh side (24) that are arranged parallel to each other and facing away from each other, the tenth side (23) being associated with the first side (3) of the semiconductor-based substrate (2), wherein respective side walls (14) that are arranged to enclose respective recessed surfaces of the set of recessed surfaces (13) comprise InP-based material of the semiconductor-based substrate (2) and/or semiconductor-based material of the at least one epitaxial semiconductor-based layer of the layer stack (22).

8. An opto-electronic assembly (100) comprising:
- a photonic integrated circuit (1) according to any one of the claims 1 to 7; and
- an electronic integrated circuit (6) that comprises a substrate (7) comprising a third side (8) and a fourth side (9), the third side (8) and the fourth side (9) being arranged parallel to each other and facing away from each other, the fourth side (9) of the substrate (7) being associated with the placeholder area (5) at the first side (3) of the semiconductor-based substrate (2) of the photonic integrated circuit (1), the substrate (7) being provided with a first set of electrically conductive contact pads (10), at least one electrically conductive contact pad of the first set of electrically conductive contact pads (10) being accessible at the third side (8) of the substrate (7) or via the third side (8) of the substrate (7), each electrically conductive contact pad of the first set of electrically conductive contact pads (10) having a fifth side (11) and a sixth side (12), the sixth side (12) being associated with the substrate (7) of the electronic integrated circuit (6) and the fifth side (11) being arranged facing away from the first side (3) of the semiconductor-based substrate (2) of the photonic integrated circuit (1);
wherein fifth sides (11) of electrically conductive contact pads of the first set of electrically conductive contact pads (10) of the electronic integrated circuit (6) and eighth sides (18) of electrically conductive contact pads of the second set of electrically conductive contact pads (17) of the photonic integrated circuit (1) are electrically interconnected via at least one of wires (20) of electrically conducting material and ribbons (21) of electrically conducting material.

9. The opto-electronic assembly (100) according to claim 8, wherein the electronic integrated circuit (6) and the placeholder area (5) of the photonic integrated circuit (1) are associated with each other via an adhesive material (25) to establish a mechanical connection between the electronic integrated circuit (6) and the photonic integrated circuit (1).

10. The opto-electronic assembly (100) according to claim 9, wherein the adhesive material (25) is arranged in contact with one of:
- a seventh side (16) of an end portion (15) of at least one respective side wall (14) that is arranged to enclose a respective recessed surface of the set of recessed surfaces (13) in the placeholder area (5) of the photonic integrated circuit (1) and the fourth side (9) of the substrate (7) of the electronic integrated circuit (6);
- a seventh side (16) of an end portion (15) of at least one respective side wall (14) that is arranged to enclose a respective recessed surface of the set of recessed surfaces (13) in the placeholder area (5) of the photonic integrated circuit (1) and a first intermediate medium (26) that is arranged in contact with the fourth side (9) of the substrate (7) of the electronic integrated circuit (6), the first intermediate medium (26) comprising at least one of a polymer layer (27), a dielectric layer (28), and a metal layer (29);
- the fourth side (9) of the substrate (7) of the electronic integrated circuit (6) and a second intermediate medium (30) that is arranged in contact with a seventh side (16) of an end portion (15) of at least one respective side wall (14) that is arranged to enclose a respective recessed surface of the set of recessed surfaces (13) in the placeholder area (5) of the photonic integrated circuit (1), the second intermediate medium (30) comprising at least one of a polymer layer (31), a dielectric layer (32), and a metal layer (33);
- a first intermediate medium (26) that is arranged in contact with the fourth side (9) of the substrate (7) of the electronic integrated circuit (6) and a second intermediate medium (30) that is arranged in contact with a seventh side (16) of an end portion (15) of at least one respective side wall (14) that is arranged to enclose a respective recessed surface of the set of recessed surfaces (13) in the placeholder area (5) of the photonic integrated circuit (1), each of the first intermediate medium (26) and the second intermediate medium (30) comprising at least one of a polymer layer (27, 31), a dielectric layer (28, 32), and a metal layer (29, 33).

11. The opto-electronic assembly (100) according to claim 9 or 10, wherein the adhesive material (25) comprises an epoxy resin.

12. The opto-electronic assembly (100) according to any one of the claims 8 to 11, wherein the wires (20) of electrically conducting material and/or the ribbons (21) of electrically conducting material comprise a metal.

13. The opto-electronic assembly (100) according to claim 12, wherein the metal comprises gold.

14. An opto-electronic system (200) comprising a photonic integrated circuit (1) according to any one of the claims 1 to 7 and/or an opto-electronic assembly (100) according to any one of the claims 8 to 13, wherein the opto-electronic system (200) is one of a transmitter, a receiver, a transceiver, a coherent transmitter, a coherent receiver and a coherent transceiver.
